# EUROPEAN PATENT APPLICATION

(11) **EP 2 482 372 A2**
(43) Date of publication of application: **01.08.2012**
(21) Application number: 11190710.1
(22) Date of filing: 25.11.2011
(51) Int. Cl.: H01M 8/02, H01M 8/10, C08K 5/3472, H05K 1/16

(54) **Printed circuit board and method for manufacturing the same, and fuel cell**

(30) Priority: 26.01.2011 JP 2011014085
(71) Applicant: Nitto Denko Corporation, Ibaraki-shi Osaka 567-8680 (JP)
(72) Inventor: Inoue, Shinichi, Ibaraki-shi, Osaka 567-8680 (JP); Ebe, Hirofumi, Ibaraki-shi, Osaka 567-8680 (JP)
(74) Representative: Gill, Stephen Charles

(57) **Abstract**

A conductor layer having a predetermined pattern is formed on a base insulating layer so that its second main surface opposes the base insulating layer. A barrier layer having higher corrosion resistance to acids than that of the conductor layer is formed on its first main surface and a side surface of the conductor layer while the first main surface and the side surface of the conductor layer and the barrier layer are covered with a conductive cover layer.

## Description

### BACKGROUND OF THE INVENTION

### (1) Field of the Invention

The present invention relates to a printed circuit board and a method for manufacturing the same, and a fuel cell including the printed circuit board.

### (2) Description of Related Art

Small-sized and high-capacity cells are required for mobile devices such as mobile phones. Therefore, fuel cells capable of obtaining higher energy densities than those in conventional cells such as lithium secondary cells have been developed. The fuel cells include direct methanol fuel cells.

In the direct methanol fuel cell, methanol is decomposed with a catalyst, to form hydrogen ions. The hydrogen ions and oxygen in air are reacted with each other, to generate electric power. In this case, chemical energy can be significantly efficiently converted into electric energy so that a very high energy density can be obtained.

JP 2004-200064, A discusses a fuel cell in which a membrane electrode assembly including a fuel electrode, an air electrode, and a polymer electrolyte film is arranged between conductor layers on a substrate. The fuel electrode and the air electrode in the membrane electrode assembly and the conductor layers on the substrate are in electric contact with each other.

In the fuel cell discussed in JP 2004-200064 A, a circulation structure for circulating fuel in the fuel electrode and a circulation structure for circulating air in the air electrode are provided. When the fuel contacts the fuel electrode and the air electrode for a long time, however, the fuel electrode and the air electrode corrode. Therefore, resistances of the fuel electrode and the air electrode are increased. As a result, collection efficiencies of the fuel electrode and the air electrode are reduced.

### BRIEF SUMMARY OF THE INVENTION

The present invention is directed to providing a printed circuit board in which a conductor layer can be prevented from corroding while a resistance of the conductor layer can be reduced, and a method for manufacturing the same, and a fuel cell including the printed circuit board.

(1) According to an aspect of the present invention, a printed circuit board includes an insulating layer, a conductor layer having a predetermined pattern and having first and second main surfaces and a side surface while being formed on the insulating layer so that the second main surface opposes the insulating layer, a barrier layer formed on at least a partial region of the first main surface and the side surface of the conductor layer and having higher corrosion resistance to acids than that of the conductor layer, and a conductive cover layer that covers the first main surface and the side surface of the conductor layer and the barrier layer.

In the printed circuit board, the conductor layer having the predetermined pattern is formed on the insulating layer so that the second main surface opposes the insulating layer. The barrier layer having higher corrosion resistance to acids than that of the conductor layer is formed on at least the partial region of the first main surface and the side surface of the conductor layer while the first main surface and the side surface of the conductor layer and the barrier layer are covered with the conductive cover layer.

In this case, a by-product such as formic acid in the fuel cell can be prevented from adhering to the conductor layer. Therefore, the conductor layer can be prevented from corroding. A contact resistance between the conductor layer and the cover layer can be prevented from being increased. As a result, electric power of the fuel cell can be efficiently supplied to the exterior.

(2) The barrier layer may include a heterocyclic compound. In this case, the corrosion resistance to acids of the barrier layer can be easily increased.

(3) The heterocyclic compound may include nitrogen. In this case, the corrosion resistance to acids of the barrier layer can be more easily increased.

(4) The heterocyclic compound may include an azole-based compound. In this case, the corrosion resistance to acids of the barrier layer can be further easily increased.

(5) The heterocyclic compound may include at least one of a tetrazole derivative, a diazole derivative, a thiadiazole derivative, and a triazole derivative. In this case, the corrosion resistance to acids of the barrier layer can be further easily increased.

(6) The heterocyclic compound may include a tetrazole derivative expressed by the following formula (1), where R1 and R2 may be the same as or different from each other, and may be each a hydrogen atom or a substituent group. In this case, the corrosion resistance to acids of the barrier layer can be further easily increased.

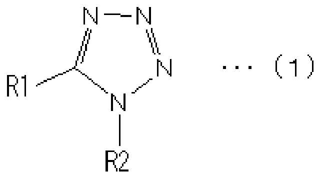

(7) The heterocyclic compound may include a benzotriazole derivative expressed by the following formula (2), where R3 and R4 may be the same as or different from each other, and may be each a hydrogen atom or a substituent group. In this case, the corrosion resistance to acids of the barrier layer can be further easily increased.

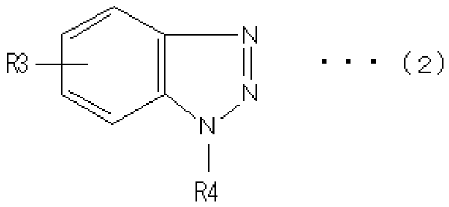

(8) The thickness of the barrier layer may be not less than 1 nm and not more than 1000 nm. In this case, the conductor layer can be sufficiently prevented from corroding. Adhesiveness between the conductor layer and the cover layer can be improved, and conductivity between the conductor layer and the cover layer can be improved.

(9) The cover layer may include a resin composition. In this case, flexibility of the printed circuit board is improved.

(10) The resin composition may include at least one of phenol resin, epoxy resin, polyester resin, polyurethane resin, and polyimide resin.

In this case, the flexibility of the printed circuit board is further improved. Particularly when the resin composition includes phenol resin or epoxy resin, the flexibility of the printed circuit board is improved, and its chemical resistance is improved.

(11) The cover layer may include a conductive material. In this case, the conductivity of the cover layer can be more sufficiently ensured.

(12) The conductive material may include at least one of a carbon material and a metal material. In this case, the conductivity of the cover layer can be further sufficiently ensured.

(13) According to another aspect of the present invention, a fuel cell includes a cell element, the printed circuit board according to the one aspect of the present invention, arranged as an electrode of the cell element, and a casing that accommodates the cell element and the printed circuit board.

In the fuel cell, the cell element and the printed circuit board are accommodated in the casing. Electric power of the cell element is taken out of the casing via the conductor layer in the printed circuit board.

In the printed circuit board, the by-product such as formic acid in the fuel cell can be prevented from adhering to the conductor layer. Thus, the conductor layer can be prevented from corroding. The contact resistance between the conductor layer and the cover layer can be prevented from being increased. As a result, the electric power of the cell element in the fuel cell can be efficiently supplied to the exterior.

(14) According to still another aspect of the present invention, a method for manufacturing a printed circuit board includes the steps of forming a conductor layer having a predetermined pattern and having first and second main surfaces and a side surface on the insulating layer so that the second main surface opposes the insulating layer, and forming a barrier layer having higher corrosion resistance to acids than that of the conductor layer on at least a partial region of the first main surface and the side surface of the conductor layer while forming a conductive cover layer that covers the first main surface and the side surface of the conductor layer and the barrier layer. The manufactured printed circuit board can be a board according to the first aspect of the present invention.

In the method for manufacturing the printed circuit board, the conductor layer having the predetermined pattern is formed on the insulating layer so that the second main surface opposes the insulating layer. The barrier layer having higher corrosion resistance to acids than that of the conductor layer is formed on at least the partial region of the first main surface and the side surface of the conductor layer while the first main surface and the side surface of the conductor layer and the barrier layer are covered with the conductive cover layer.

In this case, the by-product such as formic acid in the fuel cell can be prevented from adhering to the conductor layer. Therefore, the conductor layer can be prevented from corroding. A contact resistance between the conductor layer and the cover layer can be prevented from being increased. As a result, electric power of the fuel cell can be efficiently supplied to the exterior.

(15) The step of forming the barrier layer and the cover layer may include the steps of mixing a resin composition, a conductive material, and a heterocyclic compound, to prepare a cover layer precursor, applying the cover layer precursor to at least the partial region of the first main surface and the side surface of the conductor layer, and heating the cover layer precursor.

In this case, the resin composition, the conductive material, and the heterocyclic compound are mixed, to prepare the cover layer precursor. After the cover layer precursor is applied on the first main surface and the side surface of the conductor layer, the cover layer precursor is heated. Thus, the barrier layer composed of the heterocyclic compound is formed on at least the partial region of the first main surface and the side surface of the conductor layer (e.g. by the heterocyclic compound migrating to an interface with the conductor layer), and the cover layer composed of the resin composition containing the conductive material is formed on the barrier layer. In such a manner, the barrier layer is easily formed on the first main surface and the side surface of the conductor layer while the first main surface and the side surface of the conductor layer and the barrier layer can be easily covered with the cover layer.

(16) The step of forming the barrier layer and the cover layer may include the steps of forming a barrier layer having higher corrosion resistance to acids than that of the conductor layer on at least the partial region of the first main surface and the side surface of the conductor layer, and forming a conductive cover layer that covers the main surface and the side surface of the conductor layer and the barrier layer.

In this case, the barrier layer is formed on at least the partial region of the first main surface and the side surface of the conductor layer, and the first main surface and the side surface of the conductor layer and the barrier layer are then covered with the cover layer. Thus, the barrier layer can be reliably formed on at least the partial region of the first main surface and the side surface of the conductor layer.

According to the present invention, the conductor layer in the printed circuit board can be prevented from corroding while the resistance of the conductor layer can be reduced.

Other features, elements, characteristics, and advantages of the present invention will become more apparent from the following description of preferred embodiments of the present invention with reference to the attached drawings.

### BRIEF DESCRIPTION OF THE SEVERAL VIEWS OF THE DRAWING

Figs. 1 (a) and 1 (b) illustrate a flexible printed circuit board according to an embodiment of the present invention;
Figs. 2 (a) to 2 (d) are sectional views for illustrating steps of a first method for manufacturing the flexible printed circuit board;
Figs. 3 (a) to 3 (c) are sectional views for illustrating steps of the first method for manufacturing the flexible printed circuit board;
Fig. 4 is an external perspective view of a fuel cell using the flexible printed circuit board;
Fig. 5 illustrates functions in the fuel cell;
Figs. 6 (a) to 6 (d) are sectional views for illustrating steps of a second method for manufacturing a flexible printed circuit board;
Figs. 7 (a) to 7 (d) are sectional views for illustrating steps of methods for manufacturing flexible printed circuit boards in inventive examples 1 to 7, inventive examples 9 to 12, and comparative examples 1 and 2;
Figs. 8 (a) to 8 (c) are sectional views for illustrating steps of a method for manufacturing the flexible printed circuit board in the inventive example 8;
Figs. 9 (a) to 9 (c) are sectional views of the flexible printed circuit boards in the inventive examples 1 to 12 and the comparative examples 1 and 2; and
Fig. 10 is a schematic view illustrating methods for measuring contact resistances of the flexible printed circuit boards in the inventive examples 1 to 12 and the comparative examples 1 and 2.

### DESCRIPTION OF THE PREFERRED EMBODIMENTS

A printed circuit board according to an embodiment of the present invention will be described below with reference to the drawings. In the present embodiment, a flexible printed circuit board having flexibility will be described as an example of a printed circuit board.

### (1) Configuration of Flexible Printed Circuit Board

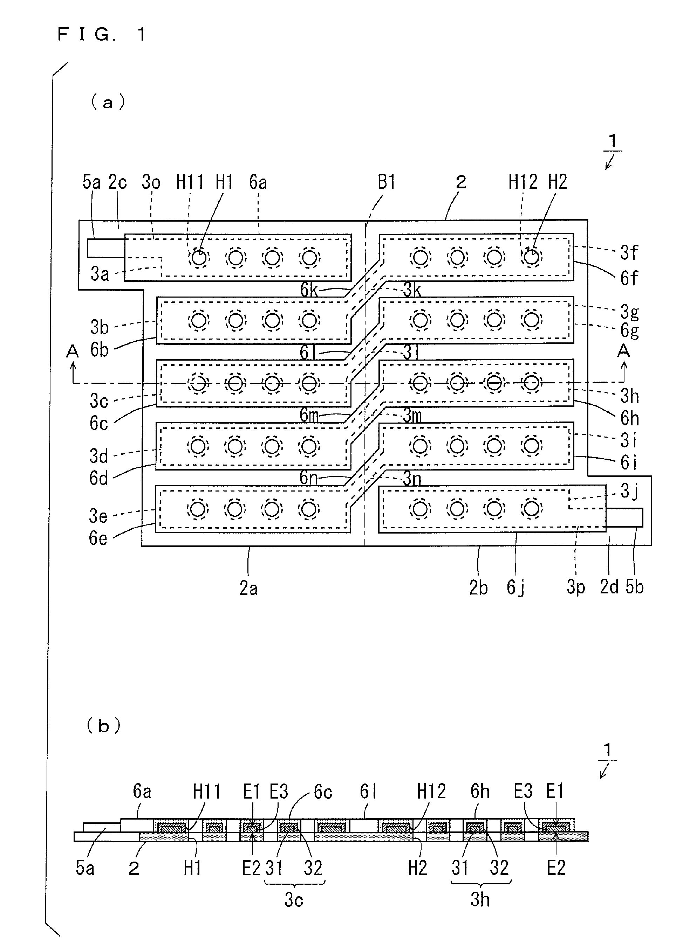

Fig. 1 (a) is a plan view of a flexible printed circuit board according to an embodiment of the present invention, and Fig. 1 (b) is a sectional view taken along a line A-A of the flexible printed circuit board illustrated in Fig. 1 (a). In the following description, a flexible wiring circuit board is abbreviated as an FPC board.

As illustrated in Figs. 1 (a) and 1 (b), an FPC board 1 includes a base insulating layer 2 composed of polyimide, for example. The thickness of the base insulating layer 2 is preferably not less than 1 µm and not more than 100 µm, more preferably not less than 5 µm and not more than 50 µm, and still more preferably not less than 5 µm and not more than 30 µm. If the thickness of the base insulating layer 2 is 1 µm or more, durability and handleability of the base insulating layer 2 are improved. If the thickness of the base insulating layer 2 is 100 µm or less, flexibility of the base insulating layer 2 is improved while the FPC board 1 becomes easy to thin.

The base insulating layer 2 includes a first insulating portion 2a, a second insulating portion 2b, a third insulating portion 2c, and a fourth insulating portion 2d. The first insulating portion 2a and the second insulating portion 2b each have a rectangular shape, and are integrally formed while being adjacent to each other. Hereinafter, sides that are parallel to a boundary line between the first insulating portion 2a and the second insulating portion 2b are referred to as lateral sides, and a pair of sides perpendicular to the lateral sides of the first insulating portion 2a and the second insulating portion 2b are referred to as end sides.

The third insulating portion 2c extends from a part of the lateral side at a corner of the first insulating portion 2a. The fourth insulating portion 2d extends from a part of the lateral side at a corner of the second insulating portion 2b at a diagonal position of the corner of the first insulating portion 2a.

A bend portion B1 is provided on a boundary line between the first insulating portion 2a and the second insulating portion 2b to divide the base insulating layer 2 into two substantially equal parts. As described below, the base insulating layer 2 can be bent along the bend portion B1. The bend portion B1 may be a shallow groove with a line shape or a mark with a line shape, for example. Alternatively, there may be nothing at the bend portion B1 if the base insulating layer 2 can be bent at the bend portion B1. When the base insulating layer 2 is bent along the bend portion B1, the first insulating portion 2a and the second insulating portion 2b oppose each other. In this case, the third insulating portion 2c and the fourth insulating portion 2d do not oppose each other.

A plurality of openings H1 (a total of 20 openings H1 including four openings in a direction of the end sides and five openings in a direction of the lateral sides in this example) are formed in the first insulating portion 2a. A plurality of openings H2 (a total of 20 openings H2 including four openings in a direction of the end sides and five openings in a direction of the lateral sides in this example) are formed in the second insulating portion 2b.

Rectangular collector portions 3a, 3b, 3c, 3d, 3e, 3f, 3g, 3h, 3i, and 3j, connection conductor portions 3k, 3l, 3m, and 3n, and drawn-out conductor portions 3o and 3p are formed on one surface of the base insulating layer 2. As illustrated in Fig. 1 (b), each of the collector portions 3a to 3j, the connection conductor portions 3k to 3n, and the drawn-out conductor portions 3o and 3p includes a conductor layer 31 and a barrier layer 32. Only the collector portions 3c and 3h are illustrated in Fig. 1 (b).

The conductor layer 31 is composed of copper, for example, and has main surfaces E1 and E2 and a side surface E3. The side surface E3 includes an outer peripheral surface of the conductor layer 30 and an inner peripheral surface of the opening. The conductor portions 3a to 3j, the connection conductor portions 3k to 3n, and the drawn-out conductor portions 3o and 3p are provided on the base insulating layer 2 so that the main surface E2 of the conductor layer 31 opposes the base insulating layer 2. In the conductor portions 3a to 3j, the connection conductor portions 3k to 3n, and the drawn-out conductor portions 3o and 3p, the main surface E1 and the side surface E3 of the conductor layer 31 are covered with a barrier layer 32. The main surface E2 of the conductor layer 31 is not covered with the barrier layer 32.

The thickness of the conductor layer 31 is preferably not less than 1 µm and not more than 100 µm, more preferably not less than 5 µm and not more than 70 µm, and still more preferably not less than 10 µm and not more than 50 µm. If the thickness of the conductor layer 31 is 1 µm or more, durability, handleability, and conductivity of the conductor layer 31 are improved. If the thickness of the conductor layer 31 is 100 µm or less, flexibility of the conductor layer 31 is improved while the FPC board 1 becomes easy to thin.

The barrier layer 32 is provided to prevent a by-product such as formic acid in a fuel cell from adhering to the conductor layer 31. Thus, the conductor layer 31 is prevented from corroding. The barrier layer 32 is preferably composed of a heterocyclic compound, more preferably a five-membered heterocyclic compound, and still more preferably a five-membered heterocyclic compound containing nitrogen (an azole-based compound). The azole-based compound includes a tetrazole derivative, a diazole derivative, a thiadiazole derivative, or a triazole derivative. In this case, corrosion resistance to acids of the barrier layer can be increased.

The following formula (1) expresses an example of a structure of the tetrazole derivative. In the formula (1), R1 and R2 are the same as or different from each other, and are each a hydrogen atom or a substituent group. The substituent group includes an alkyl group (CₙH₂ₙ₊₁; n = 1 to 12) having 1 to 12 carbons, a phenyl group, an amino group, a mercapto group, an aromatic containing functional group, an alkoxy group, an alkylamino group, an alkoxy carbonyl group, or a carboxyl group:

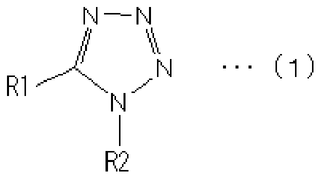

The tetrazole derivative includes a 1H-tetrazole derivative, a 5-amino-1H-tetrazole derivative, a 5-methyl-1 H-tetrazole derivative, or a 5-phenyl-1 H-tetrazole derivative.

The diazole derivative includes an imidazole derivative or a pyrazole derivative.

The thiazole derivative includes a 2,5-dimethylcapto-1,3,4-thiadiazole derivative or a 2-carboxymethylthio-5-mercapto-1,3,4-thiadiazole derivative.

The triazole derivative includes a benzotriazole derivative, a tolyltriazole derivative, a tolyltriazole salt, a 1H-1,2,3-triazole derivative, 1H-1,2,4-triazole derivative, 1,2,3-triazole-4,5-dicarboxylic acid, a 3,5-diamino-1,2,4-triazole derivative, or a 3-amino-1,2,4-triazole derivative.

The following formula (2) expresses an example of a structure of the benzotriazole derivative. In the formula (2), R3 and R4 are the same as or different from each other, and are each a hydrogen atom or a substituent group. The substituent group is an alkyl group (CₙH₂ₙ₊₁; n = 1 to 12) having 1 to 12 carbons, a phenyl group, an amino group, a mercapto group, an aromatic containing functional group, an alkoxy group, an alkylamino group, an alkoxycarbonyl group, or a carboxyl group. R3 may be arranged at any position of a benzene ring:

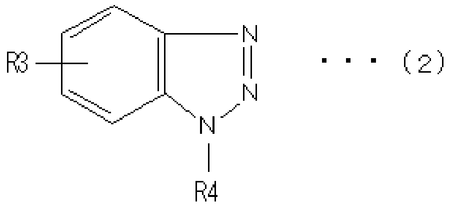

The benzotriazole derivative includes a 5-methyl benzotriazole derivative, 1H-benzotriazole-5-carboxylic acid, a carboxy benzotriazole derivative, a 1H-4,5-methyl benzotriazole derivative, or a 2-(3, 5-di-t-butyl-2-hydroxyphenyl) benzotriazole derivative.

The azole-based compound is preferably a tetrazole derivative or a benzotriazole derivative, and is more preferably a 5-methyl-1H-tetrazole derivative, a 5-phenyl-1H-tetrazole derivative, a 5-methyl benzotriazole derivative, or a tolyltriazole derivative.

The thickness of the barrier layer 32 is preferably not less than 1 nm and not more than 1000 nm, and more preferably not less than 10 nm and not more than 500 nm. If the thickness of the barrier layer 32 is 1 nm or more, the conductor layer 31 can be sufficiently prevented from corroding. If the thickness of the barrier layer 32 is 1000 nm or less, adhesiveness between the conductor layer 31 and the cover layers 6a to 6n, described below, is improved while conductivity between the conductor layer 31 and the cover layers 6a to 6n is improved.

Each of the collector portions 3a to 3j has a rectangular shape. The collector portions 3a to 3e extend parallel to the end sides of the first insulating portion 2a, and are provided in a direction of the lateral sides of the first insulating portion 2a. Each of the collector portions 3a to 3e is formed in a region, including four openings H1 arranged parallel to the end sides of the first insulating portion 2a, of the first insulating portion 2a.

Similarly, the collector portions 3f to 3j extend parallel to the end sides of the second insulating portion 2b, and are provided in a direction of the lateral sides of the second insulating portion 2b. Each of the collector portions 3f to 3j is formed in a region, including four openings H2 arranged parallel to the end sides of the second insulating portion 2b, of the second insulating portion 2b.

In this case, the collector portions 3a to 3e and the collector portions 3f to 3j are arranged at positions that are symmetric about the bend portion B1.

Each of the connection conductor portions 3k to 3n is formed over the first insulating portion 2a and the second insulating portion 2b to intersect the bend portion B1. The connection conductor portion 3k electrically connects the collector portion 3b and the collector portion 3f to each other, the connection conductor portion 31 electrically connects the collector portion 3c and the collector portion 3g to each other, the connection conductor portion 3m electrically connects the collector portion 3d and the collector portion 3h to each other, and the connection conductor portion 3n electrically connects the collector portion 3e and the collector portion 3i to each other.

An opening H11 having a larger diameter than that of the opening H1 of the first insulating portion 2a is formed in a portion, on the opening H1, of each of the collector portions 3a to 3e. An opening H12 having a larger diameter than that of the opening H2 of the second insulating portion 2b is formed in a portion, on the opening H2, of each of the collector portions 3f to 3j.

The drawn-out conductor portion 3o linearly extends from an outer short side of the collector portion 3a onto the third insulating portion 2c. The drawn-out conductor portion 3p linearly extends from an outer short side of the collector portion 3j onto the fourth insulating portion 2d.

A cover layer 6a is formed on the first insulating portion 2a to cover the collector portion 3a and a part of the drawn-out conductor portion 3o. Thus, the tip of the drawn-out conductor portion 3o is exposed while not covered with the cover layer 6a. The exposed portion of the drawn-out conductor portion 3o is referred to as a drawn-out electrode 5a. Cover layers 6b, 6c, 6d, and 6e are formed on the first insulating portion 2a to cover the collector portions 3b to 3e, respectively. The cover layers 6a to 6e contact an upper surface of the first insulating portion 2a inside the openings H11 of the collector portions 3a to 3e, respectively.

A cover layer 6j is formed on the second insulating portion 2b to cover the collector portion 3j and a part of the drawn-out conductor portion 3p. Thus, the tip of the drawn-out conductor portion 3p is exposed while not covered with the cover layer 6j. The exposed portion of the drawn-out conductor portion 3p is referred to as a drawn-out electrode 5b. Cover layers 6f, 6g, 6h and 6i are formed on the second insulating portion 2b to cover the collector portions 3f to 3i, respectively. The cover layers 6f to 6j contact an upper surface of the second insulating portion 2b inside the openings H12 of the collector portions 3f to 3j, respectively.

Cover layers 6k, 61, 6m, and 6n are formed on the first insulating portion 2a and the second insulating portion 2b to cover the connection conductor portions 3k to 3n, respectively. Each of the cover layers 6a to 6n is composed of a resin composition containing a conductive material. Therefore, the cover layers 6a to 6n have flexibility while keeping conductivity. Even when the FPC board 1 is used while being bent, the cover layers 6a to 6n are sufficiently prevented from being damaged.

A mixed amount of the conductive material is preferably not less than 1 part by weight and not more than 90 parts by weight, more preferably not less than 10 parts by weight and not more than 70 parts by weight, and still more preferably not less than 40 parts by weight and not more than 70 parts by weight to 100 parts by weight of a mixed amount of the resin composition. If the mixed amount of the conductive material is 1 part by weight or more to 100 parts by weight of the mixed amount of the resin composition, conductivity can be provided to the cover layers 6a to 6n. If the mixed amount of the conductive material is 90 parts by weight or less to 100 parts of the mixed amount of the resin composition, the resin composition can be reliably cured.

The thickness of the cover layers 6a to 6n is preferably not less than 1 µm and not more than 100 µm, more preferably not less than 10 µm and not more than 50 µm, and still more preferably not less than 15 µm and not more than 40 µm. If the thickness of the cover layers 6a to 6n is 1 µm or more, durability and handleability of the cover layers 6a to 6n are improved while the cover layers 6a to 6n are prevented from dropping from the collector portions 3a to 3j, the connection conductor portions 3k to 3n, and the drawn-out conductor portions 3o and 3p. If the thickness of the cover layers 6a to 6n is 100 µm or less, flexibility of the cover layers 6a to 6n is improved while the FPC board 1 becomes easy to thin.

### (2) First Method for Manufacturing FPC Board

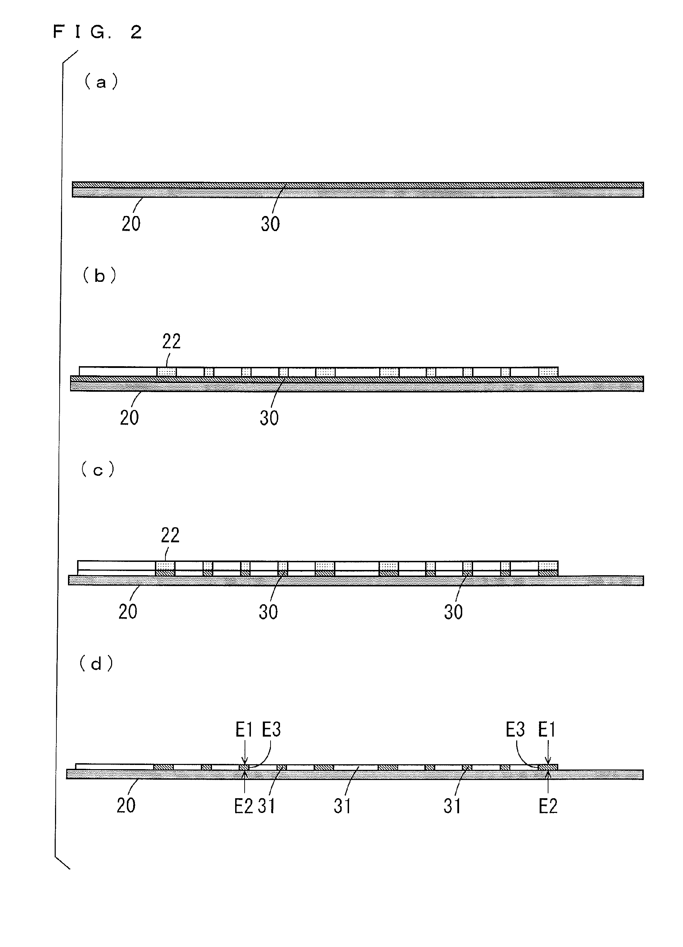

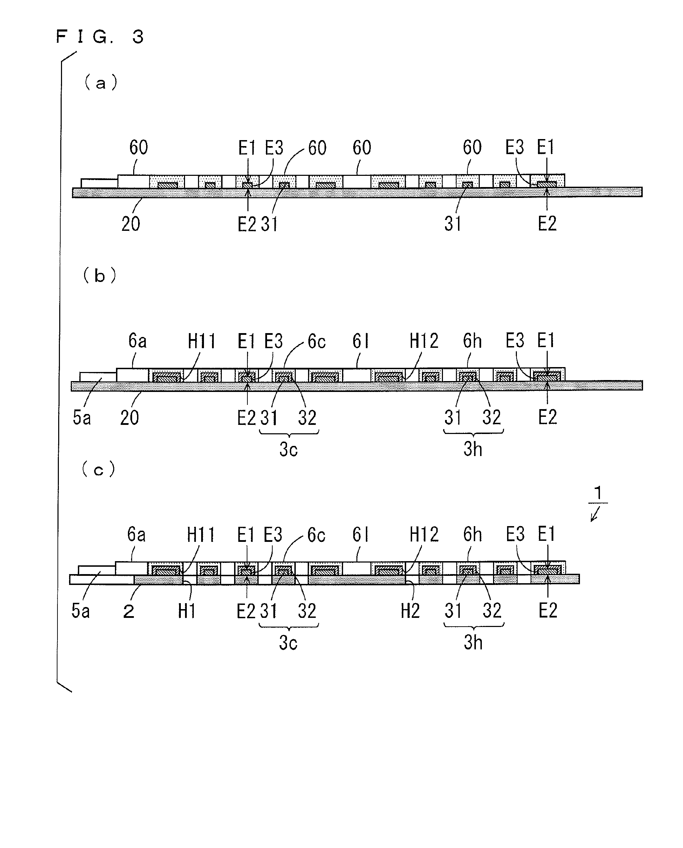

A first method for manufacturing the FPC board 1 illustrated in Fig. 1 will be described. Figs. 2 and 3 are sectional views for illustrating steps of the first method for manufacturing the FPC board 1. Figs. 2 and 3 are sectional views as viewed from the line A-A of the FPC board 1 illustrated in Fig. 1.

First, a two-layer copper clad laminate (CCL) including an insulating film 20 composed of polyimide and a conductor film 30 composed of copper, for example, is prepared, as illustrated in Fig. 2 (a). The thickness of the insulating film 20 is 25 µm, for example, and the thickness of the conductor film 30 is 18 µm, for example.

Then, an etching resist 22 having a predetermined pattern is formed on the conductor film 30, as illustrated in Fig. 2 (b). The etching resist 22 is formed by forming a resist film on the conductor film 30 of a dry film resist or the like, exposing the resist film in a predetermined pattern, and then developing the resist film.

Then, a region, excluding a region under the etching resist 22, of the conductor film 30 is then removed by etching using an etchant such as ferric chloride, as illustrated in Fig. 2 (c). The etching resist 22 is then removed by a stripping liquid, as illustrated in Fig. 2 (d). Thus, a conductor layer 31 having a predetermined pattern is formed on the insulating film 20. The conductor layer 31 has main surfaces E1 and E2 and a side surface E3. The main surface E2 contacts the insulating film 20.

The conductor layer 31 may be formed on the insulating film 20 using a general method such as sputtering, evaporation, or plating. Alternatively, the conductor film 30 may be punched out into patterns of the conductor layer 31 using laser light or a die, and the patterns of the conductor layer 31 obtained by the punching may be joined to the insulating film 20 with an adhesive or the like.

Then, a cover layer precursor 60 is applied on the insulating film 20 to cover the main surface E1 and the side surface E3 of the conductor layer 31, as illustrated in Fig. 3 (a). The thickness of the cover layer precursor 60 is 25 µm, for example. The cover layer precursor 60 is prepared when a resin composition and a conductive material are mixed with each other, for example. The above-mentioned heterocyclic compound such as a tetrazole derivative is mixed with the cover layer precursor 60.

Then, the cover layer precursor 60 is dried at a temperature of not less than 30°C and not more than 200°C for not less than 0.15 hours and not more than 5 hours, to perform curing processing, as illustrated in Fig. 3 (b). In this case, the heterocyclic compound, which has been mixed with the cover layer precursor 60, moves to an interface with the conductor layer 31. Thus, the barrier layer 32 composed of a tetrazole derivative is formed on the main surface E1 and the side surface E3 of the conductor layer 31, and remaining portions of the cover layer precursor 60 are the cover layers 6a to 6n.

In such a manner, the collector portions 3a to 3j, the connection conductor portions 3k to 3n, and the drawn-out conductor portions 3o and 3p are formed. The plurality of openings H11 are formed in each of the collector portions 3a to 3e, and the plurality of openings H12 are formed in each of the collector portions 3f to 3j. Further, the cover layers 6a to 6n are formed to cover the collector portions 3a to 3j, the connection conductor portions 3k to 3n, and the drawn-out conductor portions 3o and 3p. The drawn-out electrodes 5a and 5b are exposed from the cover layers 6a and 6j. Fig. 3 (b) illustrates only the collector portions 3c and 3h, the connection conductor portion 3l, the drawn-out electrode 5a, and the cover layers 6a, 6c, 6h, and 6l.

Finally, the insulating film 20 is cut to a predetermined shape, to form the base insulating layer 2, as illustrated in Fig. 3 (c). The plurality of openings H1 and H2 are formed in the base insulating layer 2. Thus, the FPC board 1 including the collector portions 3a to 3j, the connection conductor portions 3k to 3n, the drawn-out conductor portions 3o and 3p, and the cover layers 6a to 6n is completed. While the method for manufacturing the FPC board 1 by a subtractive method is illustrated in Figs. 2 and 3, the present invention is not limited to this. For example, another manufacturing method such as a semi-additive method may be used.

### (3) Fuel Cell Using FPC Board

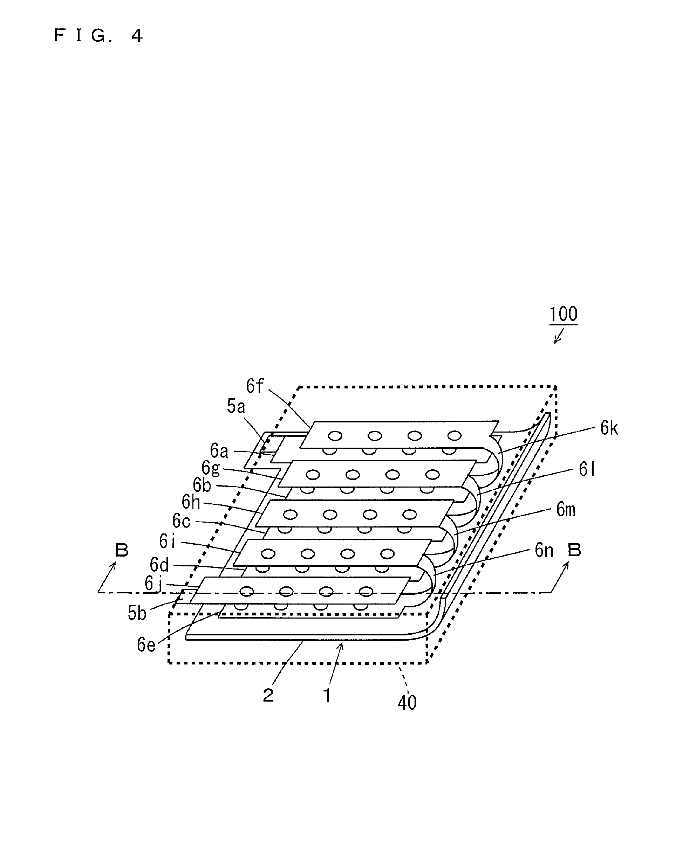

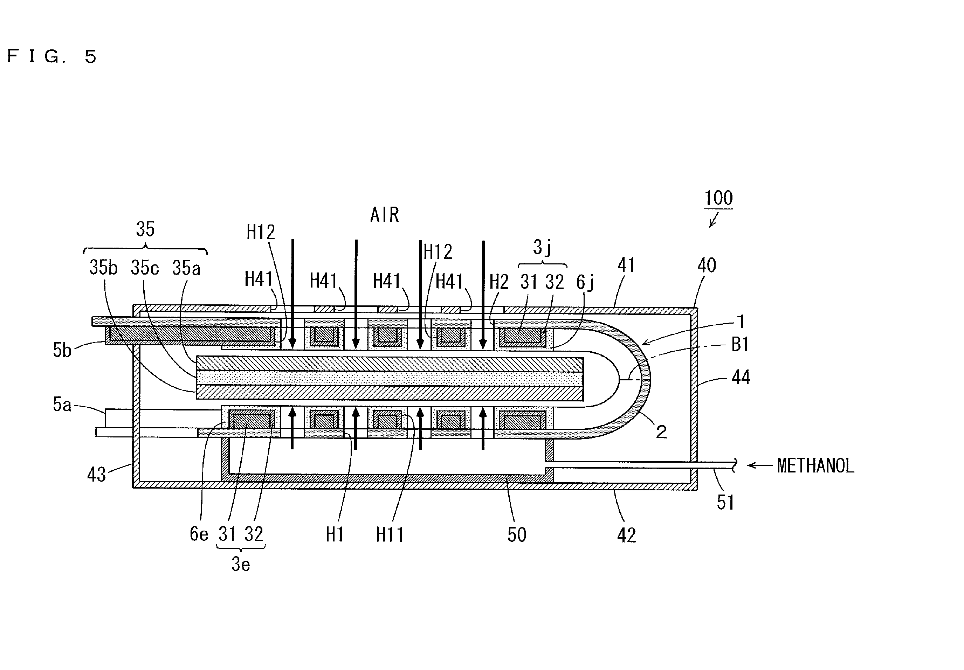

Fig. 4 is an external perspective view of a fuel cell 100 using the FPC board 1. Fig. 5 illustrates functions in the fuel cell 100, and is a sectional view taken along a line B-B of the fuel cell 100 illustrated in Fig. 4.

As illustrated in Figs. 4 and 5, the fuel cell 100 includes a casing 40 having a rectangular parallelepiped shape. The casing 40 is indicated by a broken line in Fig. 4. The casing 40 includes an upper surface portion 41, a lower surface portion 42, one side surface portion 43, and the other side surface portion 44.

The FPC board 1 is sandwiched between the upper surface portion 41 and the lower surface portion 42 in the casing 40 while being bent along the bend portion B1 illustrated in Fig. 1 with one surface, on which the cover layers 6a to 6n are formed, directed inward.

Inside the casing 40, a plurality of (five in the present embodiment) electrode films 35 are arranged between the cover layers 6a and 6f, between the cover layers 6b and 6g, between the cover layers 6c and 6h, between the cover layers 6d and 6i, and between the cover layers 6e and 6j in the bent FPC board 1 (see Fig. 1 (a)). Thus, the plurality of electrode films 35 are connected in series.

Each of the electrode films 35 includes an air electrode 35a, a fuel electrode 35b, and an electrolyte film 35c. The air electrode 35a is formed on one surface of the electrolyte film 35c, and the fuel electrode 35b is formed on the other surface of the electrolyte film 35c. The air electrodes 35a in the plurality of electrode films 35 respectively oppose the cover layers 6f to 6j in the FPC board 1, respectively, and the fuel electrodes 35b in the plurality of electrode films 35 oppose the cover layers 6a to 6e in the FPC board 1, respectively.

A plurality of openings H41 are formed on the upper surface portion 41 in the casing 40, to correspond to the plurality of openings H12 of each of the collector portions 3f to 3j and the plurality of openings H2 of the base insulating layer 2. Air is supplied to the air electrode 35a in the electrode film 35 via the plurality of openings H41 of the casing 40, the plurality of openings H2 of the base insulating layer 2, and the plurality of openings H12 of each of the collector portions 3f to 3j.

A fuel accommodating chamber 50 is provided on the lower surface portion 42 in the casing 40 to contact the first insulating portion 2a (see Fig. 1 (a)) in the base insulating layer 2. One end of a fuel supply pipe 51 is connected to the fuel accommodating chamber 50. The other end of the fuel supply pipe 51 is connected to a fuel supplier (not illustrated) provided outside via the other side surface portion 44 in the casing 40. Fuel is supplied from the fuel supplier to the fuel accommodating chamber 50 via the fuel supply pipe 51. The fuel is supplied to the fuel electrodes 35b in the electrode films 35 via the plurality of openings H1 of the base insulating layer 2 and the plurality of openings H11 of each of the collector portions 3a to 3e. In the present embodiment, methanol is used as the fuel.

In the above-mentioned configuration, methanol is decomposed into hydrogen ions and carbon dioxide in the plurality of fuel electrodes 35b, to produce electrons. The produced electrons are guided from the collector portion 3a (see Fig. 1) to the drawn-out electrode 5a in the FPC board 1. The hydrogen ions obtained by decomposing methanol permeate through the electrolyte films 35c, to reach the air electrode 35a. In the plurality of air electrodes 35a, the hydrogen ions and oxygen react with each other while the electrons guided from the drawn-out electrode 5b to the collector portion 3j, which have been consumed, to form water. In such a manner, electric power is supplied to an external circuit connected to the drawn-out electrodes 5a and 5b.

### (4) Second Method for Manufacturing FPC Board

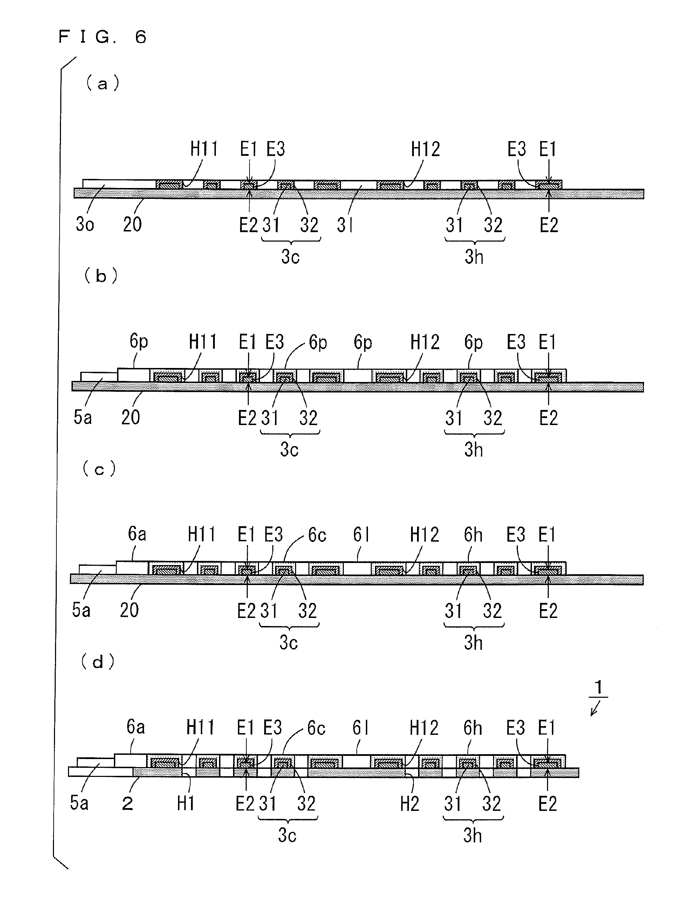

A difference of a second method for manufacturing the FPC board 1 illustrated in Fig. 1 from the first method for manufacturing the FPC board 1 will be described. Fig. 6 is a sectional view for illustrating steps of the second method for manufacturing the FPC board 1. The second method for manufacturing the FPC board 1 has similar steps to the steps illustrated in Figs. 2 (a) to 2 (d) in the first method for manufacturing the FPC board 1.

After the step illustrated in Fig. 2 (d), a barrier layer 32 composed of the above-mentioned heterocyclic compound such as a tetrazole derivative is formed by spray coating on the main surface E1 and the side surface E3 of the conductor layer 31, as illustrated in Fig. 6 (a). Thus, collector portions 3a to 3j, connection conductor portions 3k to 3n, and drawn-out conductor portions 3o and 3p are formed. A plurality of openings H11 are formed in each of the collector portions 3a to 3e, and a plurality of openings H12 are formed in each of the collector portions 3f to 3j. Fig. 6 (a) illustrates only the collector portions 3c and 3h, the connection conductor portion 3l, and the drawn-out conductor portion 3o. In the second method for manufacturing the FPC board 1, the barrier layer 32 may be formed using a general method such as a gravure coating method or a dipping method.

As illustrated in Fig. 6 (b), a cover layer precursor 6p is applied to cover the main surface E1 and the side surface E3 of the conductor layer 31. The thickness of the cover layer precursor 6p is 25 µm, for example. In the present embodiment, the above-mentioned heterocyclic compound is not mixed with the cover layer precursor 6p.

As illustrated in Fig. 6 (c), curing processing is then performed by drying the cover layer precursor 6p at a predetermined temperature for a predetermined time. Thus, cover layers 6a to 6n are formed to cover the collector portions 3a to 3j, the connection conductor portions 3k to 3n, and the drawn-out conductor portions 3o and 3p. The drawn-out electrodes 5a and 5b are exposed from the cover layers 6a and 6j. Fig. 6 (c) illustrates only the cover layers 6a, 6c, 6h, and 6l and the drawn-out electrode 5a.

Finally, as illustrated in Fig. 6 (d), an insulating film 20 is cut to a predetermined shape, to form a base insulating layer 2. A plurality of openings H1 and H2 are formed in the base insulating layer 2. Thus, an FPC board 1 including the collector portions 3a to 3j, the connection conductor portions 3k to 3n, the drawn-out conductor portions 3o and 3p, and the cover layers 6a to 6n is completed.

### (5) Effect

In the FPC board 1 according to the present embodiment, each of the collector portions 3a to 3j, the connection conductor portions 3k to 3n, and the drawn-out conductor portions 3o and 3p includes the conductor layer 31 and the barrier layer 32.

The main surface E1 and the side surface E3 of the conductor layer 31 are covered with the barrier layer 32. In this case, a by-product such as formic acid in the fuel cell 100 is prevented from adhering to the conductor layer 31. Thus, the conductor layer 31 is prevented from corroding. A contact resistance between the conductor layer 31 and the cover layers 6a to 6n is prevented from being increased. As a result, electric power of the electrode film 35 in the fuel cell 100 can be efficiently supplied to the exterior.

In the first method for manufacturing the FPC board 1, the conductive material and the heterocyclic compound are mixed with the resin composition so that the cover layer precursor 60 is prepared. After the cover layer precursor 60 is applied on the main surface E1 and the side surface E3 of the conductor layer 31, the cover layer precursor 60 is heated. Thus, the barrier layer 32 composed of a heterocyclic compound is formed on the main surface E1 and the side surface E3 of the conductor layer 31, and the cover layers 6a to 6n composed of a resin composition including a conductive material are formed on the barrier layer 32. In such a manner, the barrier layer 32 is easily formed on the main surface E1 and the side surface E3 of the conductor layer 31 while the main surface E1 and the side surface E3 of the conductor layer 31 and the barrier layer 32 can be easily covered with the cover layers 6a to 6n.

In the second method for manufacturing the FPC board 1, after the barrier layer 32 including a heterocyclic compound is formed on the main surface E1 and the side surface E3 of the conductor layer 31, the main surface E1 and the side surface E3 of the conductor layer 31 are covered with the cover layers 6a to 6n. Thus, the barrier layer 32 can be reliably formed on the main surface E1 and the side surface E3 of the conductor layer 31.

### (6) Another Embodiment

(6-1) While polyimide is used as a material for the base insulating layer 2 in the FPC board 1 in the above-mentioned embodiment, the present invention is not limited to this. For example, the polyimide may be replaced with another insulating material such as polyamide-imide, polyethylene terephthalate, polyethylene naphthalate, polyphenylene sulfide, liquid crystal polymer, polyolefin, epoxy, or polytetrafluoroethylene.

(6-2) While the base insulating layer 2 does not have continuous pores in the above-mentioned embodiment, the present invention is not limited to this. For example, the base insulating layer 2 may have continuous pores. In this case, the base insulating layer 2 has air permeability. Therefore, the FPC board 1 can be used as an electrode of the fuel cell 100 even if the openings H1 and H2 are not formed in the base insulating layer 2.

In this case, the material for the base insulating layer 2 may include an insulating material such as ePTFE (expanded polytetrafluoroethylene) having continuous pores formed therein, polyimide, polyamide-imide, polyethylene terephthalate, polyethylene naphthalate, polyphenylene sulfide, liquid crystal polymer, polyolefin, polyether-imide, polyethylene, polypropylene, epoxy, or polytetrafluoroethylene.

(6-3) While copper is used as a material for the conductor layer 31 in the above-mentioned embodiment, the present invention is not limited to this. For example, copper may be replaced with another metal such as gold (Au), silver, titanium, platinum, or aluminum, or an alloy such as a copper alloy, a gold alloy, a silver alloy, a titanium alloy, a platinum alloy, or an aluminum alloy. Even in this case, the conductivity of the cover layers 6a to 6n can be sufficiently ensured.

(6-4) In the above-mentioned embodiment, the resin composition composing the cover layers 6a to 6n may include polyester resin, polyurethane resin, polyacrylic resin, epoxy resin, phenol resin, polyimide resin, acrylic resin, or polyamide-imide resin, or resin that is a mixture of two or more types of resins. In this case, flexibility of the FPC board 1 is improved. Particularly if the resin composition includes phenol resin or epoxy resin, the flexibility of the FPC board 1 is improved, and its chemical resistance is improved.

(6-5) In the above-mentioned embodiment, the conductive material for the cover layers 6a to 6n may include a carbon material such as carbon black, graphite, a carbon nanotube, or a carbon fiber, a metal material such as gold (Au), silver, a nano silver particle, or a conductive polymer material such as polythiophene or polyaniline, or a material that is a mixture of two or more types of the materials.

(6-6) In the above-mentioned embodiment, the FPC board 1 includes the five pairs of collector portions (collector portions 3a and 3f, collector portions 3b and 3g, collector portions 3c and 3h, collector portions 3d and 3i, and collector portions 3e and 3j), the present invention is not limited to this. The number of collector portions in the FPC board 1 may be four or less or six or more as long as it is two or more. Thus, any number of electrode films 35 can be connected in series.

The FPC board 1 may have a pair of collector portions. In this case, the connection conductor portions 3k to 3n are not provided.

(6-7) While the printed circuit board is the FPC board 1 having flexibility in the above-mentioned embodiment, the present invention is not limited to this. For example, the printed circuit board may be a rigid printed circuit board if it has no flexibility.

(6-8) While the cover layers 6a to 6n are formed in the collector portions 3a to 3j, the connection conductor portions 3k to 3n, and the drawn-out conductor portions 3o and 3p in the above-mentioned embodiment, the present invention is not limited to this. If formic acid or the like does not adhere to the drawn-out conductor portions 3o and 3p, for example, the cover layers 6a to 6n may be formed in only the collector portions 3a to 3j and the connection conductor portions 3k to 3n.

### (7) Correspondences between Elements in the Claims and Parts in Embodiments

In the following paragraphs, non-limiting examples of correspondences between various elements recited in the claims below and those described above with respect to various preferred embodiments of the present invention are explained.

In the above-mentioned embodiment, the base insulating layer 2 is an example of an insulating layer, the main surface E1 is an example of a first main surface, the main surface E2 is an example of a second main surface, the side surface E3 is an example of a side surface, the conductor layer 31 is an example of a conductor layer, the barrier layer 32 is an example of a barrier layer, the cover layers 6a to 6n are examples of a cover layer, the FPC board 1 is an example of a printed circuit board, the electrode film 35 is an example of a cell element, the casing 40 is an example of a casing, and the cover layer precursor 60 is an example of a cover layer precursor.

As each of various elements recited in the claims, various other elements having configurations or functions described in the claims can be also used.

### (8) Inventive Examples

### (8-1) Inventive Examples and Comparative Examples

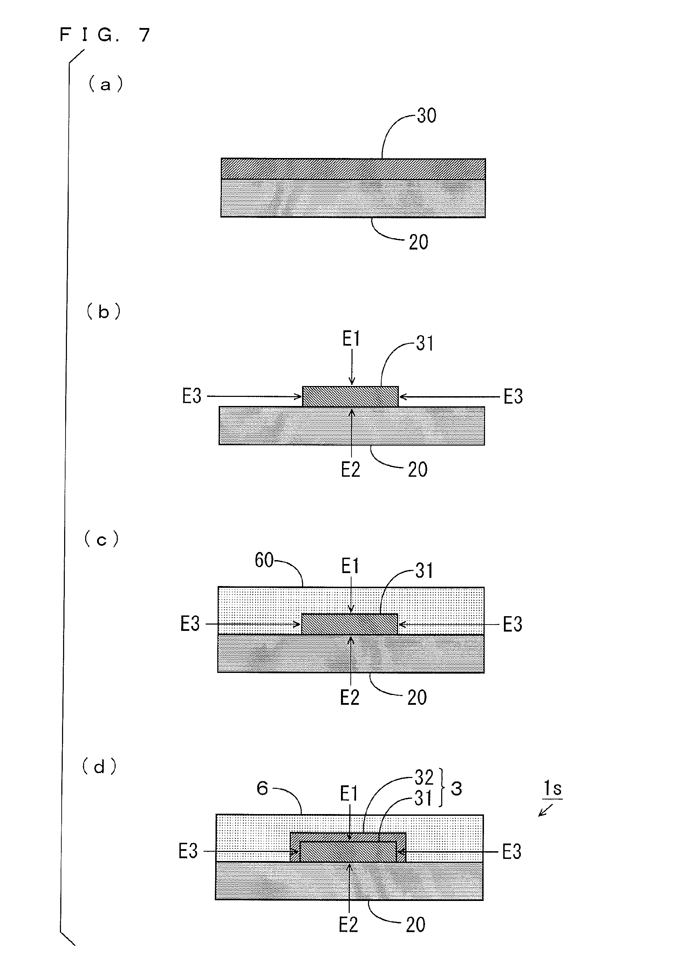

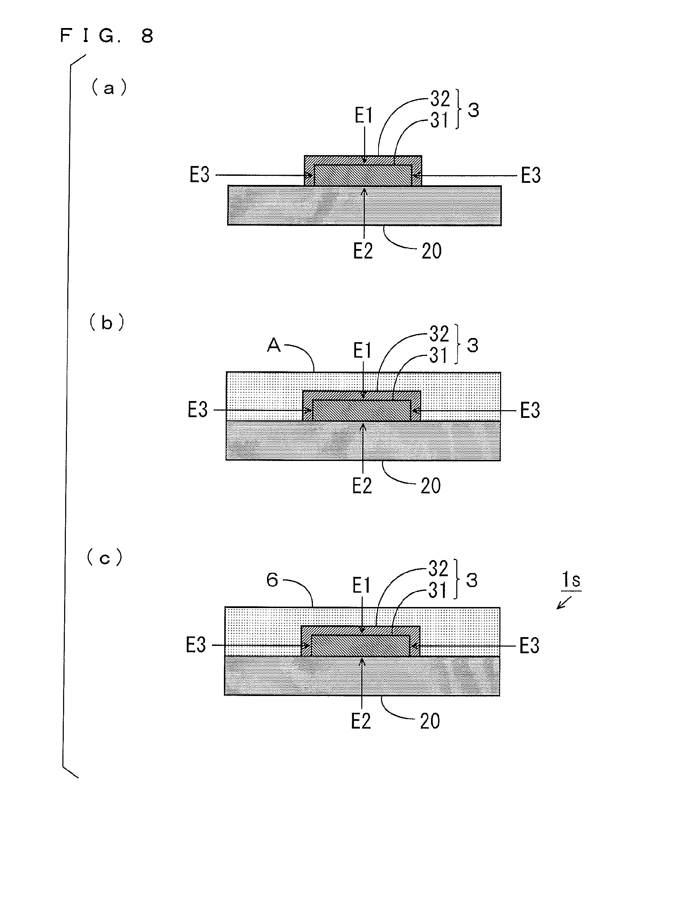

In inventive examples 1 to 12 and comparative examples 1 and 2, described below, a cover layer precursor was prepared in the following method based on the above-mentioned embodiment. Then, an FPC board, described below, was manufactured using the cover layer precursor. Fig. 7 is a sectional view for illustrating steps of a method of manufacturing an FPC board in each of the inventive examples 1 to 7, the inventive examples 9 to 12, and the comparative examples 1 and 2. Fig. 8 is a sectional view for illustrating steps of a method for manufacturing an FPC board in the inventive example 8.

In the inventive example 1, 75 parts by weight of dimethyl terephthalic acid, 40 parts by weight of dimethyl isophthalic acid, 80 parts by weight of ethylene glycol, 60 parts by weight of neopentyl glycol, and 0.1 parts by weight of tetrabutyl titanate were mixed in a four-necked flask including a Vigreux fractionating column, and their mixture was subjected to ester exchange at a temperature of 180°C for three hours. 2 parts by weight of trimellitic anhydride and 80 parts by weight of sebacic acid were then mixed with the mixture, and their mixture was subjected to dehydration reaction for one hour. An atmosphere around the mixture was then gradually depressurized to 1 mm Hg or less, and the mixture was subjected to polymerization reaction at a temperature of 270°C for two hours, to produce polyester resin.

40 parts by weight of the polyester resin, which was produced in the four-necked flask, and 100 parts by weight of diethylene glycol monoethyl ether acetate were then mixed, and their mixture was dissolved at a temperature of 80°C. Then, the mixture was cooled to a normal temperature, and 5 parts by weight of a block member of hexamethylene diisocyanate (DURANATE manufactured by ASAHI KASEI CHEMICALS CORPORATION) was mixed with the mixture, to produce a resin composition.

10 parts by weight of conductive carbon black (Ketjenblack EC-DJ600 manufactured by Lion Corporation) and 45 parts by weight of graphite (manufactured by Nippon Graphite Industries, Ltd.) were then mixed as conductive components with 45 parts by weight of an application liquid of the resin composition. Then, the conductive carbon black and the graphite in their mixture were dispersed using a triple roll machine, to prepare a cover layer precursor A.

On the other hand, as illustrated in Fig. 7 (a), a two-layer CCL including an insulating film 20 and a conductive film 30 was prepared. Then, as illustrated in Fig. 7 (b), the two-layer CCL was etched using ferric chloride, to form a conductor layer 31 having a predetermined pattern on the insulating film 20.

Then, 0.8 parts by weight of a 5-phenyl-1H-tetrazole derivative was mixed as a heterocyclic compound with the above-mentioned cover layer precursor A, to prepare a cover layer precursor 60. As illustrated in Fig. 7 (c), the cover layer precursor 60 was applied on a main surface E1 and a side surface E3 of the conductor layer 31, followed by drying at a temperature of 150°C for thirty minutes, to perform curing processing of the cover layer precursor 60.

In such a manner, as illustrated in Fig. 7 (d), an FPC board 1s in the inventive example 1 was prepared. In the FPC board 1s, a collector portion 3 including a conductor layer 31 and a barrier layer 32 was formed on the insulating layer 20. A cover layer 6 was formed on the insulating layer 20 to cover the collector portion 3. The thickness of the cover layer 6 was 25 µm.

In the inventive example 2, an FPC board 1s was prepared in a similar method to that in the inventive example 1 except that the cover layer precursor A in the inventive example 1 was replaced with a cover layer precursor B, described below.

10 parts by weight of conductive carbon black (Ketjenblack EC-DJ600 manufactured by Lion Corporation) and 45 parts by weight of graphite (manufactured by Nippon Graphite Industries, Ltd.) were mixed as conductive components with 41 parts by weight of epoxy resin (jER-1007 manufactured by Japan Epoxy Resin Co., Ltd.), which was dissolved in methyl ethyl ketone (MEK). The conductive carbon black and the graphite in their mixture were then dispersed using a triple roll machine. 3.3 parts by weight of acid anhydride (MH-700 manufactured by New Japan Chemical Co., Ltd.) serving as a curing agent and 2 parts by weight of imidazole (2E4MZ manufactured by SHIKOKU CHEMICALS CORPORATION) serving as a catalyst were mixed with the mixture, to prepare a cover layer precursor B. 0.8 parts by weight of a 5-phenyl-1H-tetrazole derivative was mixed with the cover layer precursor B, to prepare a cover layer precursor 60.

In the inventive example 3, an FPC board 1s was prepared in a similar method to that in the inventive example 1 except that the cover layer precursor A in the inventive example 1 was replaced with a cover layer precursor C, described below.

36 parts by weight of resol phenol resin (PHENOLITE 5010 manufactured by DIC Corporation) and 9 parts by weight of bisphenol A epoxy resin (jER-1007 manufactured by Japan Epoxy Resin Co., Ltd.) were previously mixed with ethyl carbitol, and 10 parts by weight of conductive carbon black (Ketjenblack EC-DJ600 manufactured by Lion Corporation) and 45 parts by weight of graphite (manufactured by Nippon Graphite Industries, Ltd.) were mixed as conductive components with their mixture. Then, the conductive carbon black and the graphite in their mixture were dispersed using a triple roll machine, to prepare a cover layer precursor C. 0.8 parts by weight of a 5-phenyl-1H-tetrazole derivative was mixed as a heterocyclic compound with the cover layer precursor C, to prepare a cover layer precursor 60.

In the inventive example 4, an FPC board 1s was prepared in a similar method to that in the inventive example 1 except that a 5-methyl-1H-tetrazole derivative was mixed in place of a 5-phenyl-1H-tetrazole derivative as a heterocyclic compound with a cover layer precursor 60.

In the inventive example 5, an FPC board 1s was prepared in a similar method to that in the inventive example 1 except that a 5-methyl benzotriazole derivative was mixed in place of a 5-phenyl-1H-tetrazole derivative as a heterocyclic compound with a cover layer precursor 60.

In the inventive example 6, an FPC board 1s was prepared in a similar method to that in the inventive example 1 except that not 0.8 parts by weight but 0.3 parts by weight of a 5-phenyl-1H-tetrazole derivative was mixed with a cover layer precursor 60.

In the inventive example 7, an FPC board 1s was prepared in a similar method to that in the inventive example 1 except that not 0.8 parts by weight but 5 parts by weight of a 5-phenyl-1H-tetrazole derivative was mixed with a cover layer precursor 60.

A method for manufacturing an FPC board 1s in the inventive example 8 has similar steps to the steps illustrated in Figs. 7 (a) and 7 (b) in the method for manufacturing the FPC board 1s in each of the inventive examples 1 to 7 while having steps illustrated in Figs. 8 (a), 8 (b), and 8 (c) in place of steps illustrated in Figs. 7 (c) and 7 (d).

After the step illustrated in Fig. 7 (b), methanol with which 0.6 % by weight of a 5-phenyl-1H-tetrazole derivative was mixed was applied on a main surface E1 and a side surface E3 of a conductor layer 31 using a wire bar. Then, the applied methanol was dried at a temperature of 50°C for three minutes, to form a barrier layer 32 on the main surface E1 and the side surface E3 of the conductor layer 31, as illustrated in Fig. 8 (a). Thus, a collector portion 3 including the conductor layer 31 and the barrier layer 32 was formed on an insulating layer 20.

As illustrated in Fig. 8 (b), the cover layer precursor A in the inventive example 1 was applied on the insulating film 20 to cover the collector portion 3, followed by drying at a temperature of 180°C for 30 minutes, to perform curing processing of the cover layer precursor A. In such a manner, the FPC board 1s in the inventive example 8 was prepared, as illustrated in Fig. 8 (c). In the FPC board 1s, a cover layer 6 was formed on the insulating film 20 to cover the collector portion 3. The thickness of the cover layer 6 was 25 µm.

In the inventive example 9, an FPC board 1s was prepared in a similar method to that in the inventive example 5 except that not 0.8 parts by weight but 0.3 parts by weight of a 5-methyl benzotriazole derivative was mixed with a cover layer precursor 60.

In the inventive example 10, an FPC board 1s was prepared in a similar method to that in the inventive example 5 except that not 0.8 parts by weight but 5 parts by weight of a 5-methyl benzotriazole derivative was mixed with a cover layer precursor 60.

In the inventive example 11, an FPC board 1s was prepared in a similar method to that in the inventive example 1 except that not 0.8 parts by weight but 0.001 parts by weight of a 5-phenyl-1H-tetrazole derivative was mixed with a cover layer precursor 60.

In the inventive example 12, an FPC board 1s was prepared in a similar method to that in the inventive example 1 except that not 0.8 parts by weight but 20 parts by weight of a 5-phenyl-1H-tetrazole derivative was mixed with a cover layer precursor 60.

In the comparative example 1, an FPC board 1s was prepared in a similar method to that in the inventive example 1 except that a cover layer precursor 60 was replaced with a cover layer precursor having no heterocyclic compound mixed therewith.

In the comparative example 2, an FPC board 1s was prepared in a similar method to that in the inventive example 2 except that a cover layer precursor 60 was replaced with a cover layer precursor having no heterocyclic compound mixed therewith.

### (8-2) Measurement of Thickness of Barrier Layer and Measurement of Contact Resistance of FPC Board

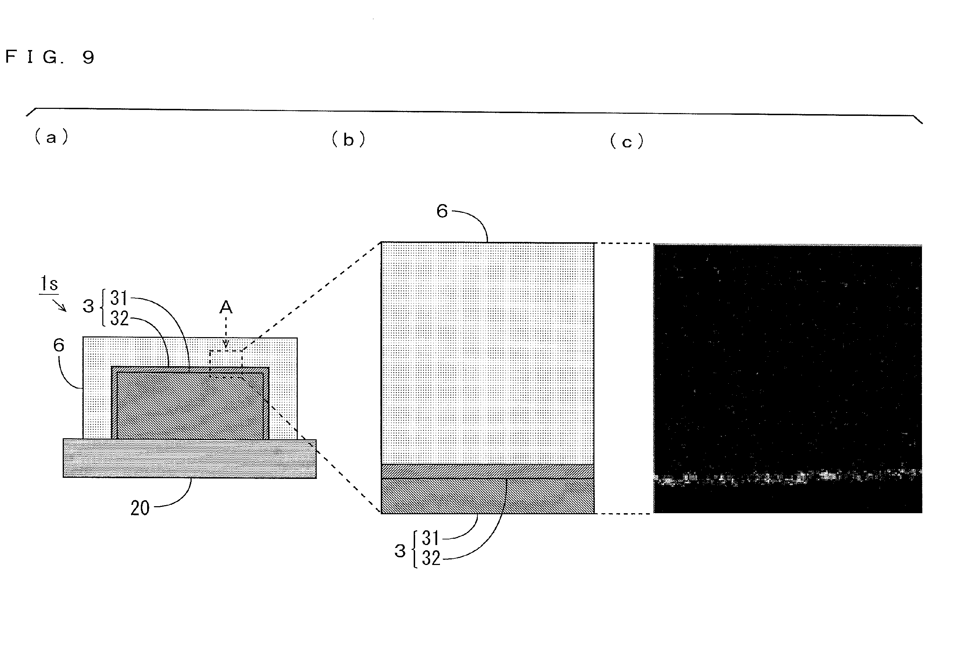

Fig. 9 is a sectional view of the FPC boards 1s in the inventive examples 1 to 12 and the comparative examples 1 and 2. As illustrated in Fig. 9 (a), the FPC boards 1s in the inventive examples 1 to 12 and the comparative examples 1 and 2 were cut along a surface perpendicular to the insulating film 20. Fig. 9 (b) is an enlarged sectional view of a portion A illustrated in Fig. 9 (a). A composition in a cross section of the FPC board 1s illustrated in Fig. 9 (b) was analyzed using a time-of-flight secondary ion mass spectrometer (TOF-SIMS5 manufactured by ION-TOF GmbH), and the thickness of the barrier layer 32 was measured from a distributed state of a heterocyclic compound. Fig. 9 (c) illustrates an analysis result by the time-of-flight secondary ion mass spectrometer of the FPC board 1s in the inventive example 1 and an ion image of C₇H₅N₄⁻.

The FPC boards 1s in the inventive examples 1 to 12 and the comparative examples 1 and 2 were immersed in a formic acid solution having a density of 1000 ppm and a temperature of 50°C for seven days. Then, the presence or absence of corrosion of the conductor layer 31 in the FPC board 1s and a contact resistance of the FPC board 1s were measured.

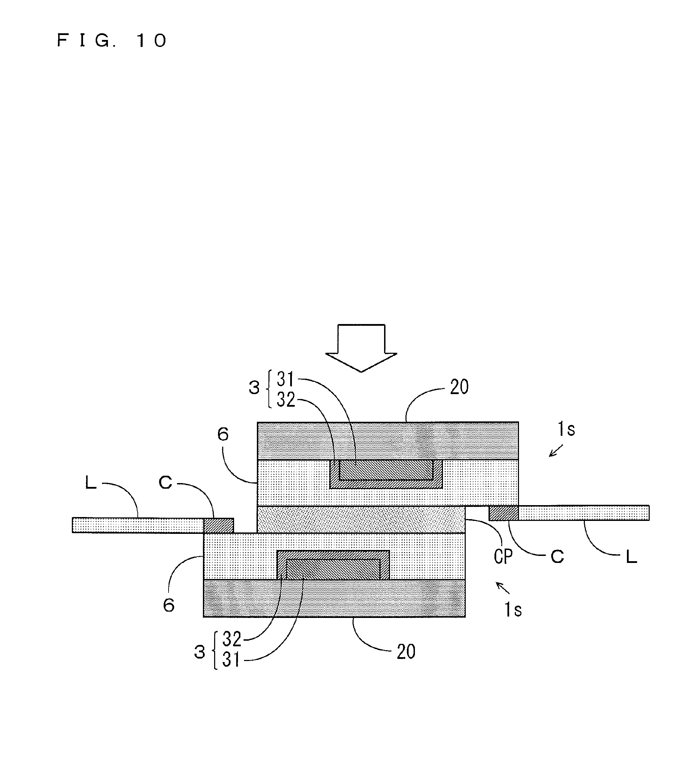

Fig. 10 is a schematic view illustrating a method for measuring contact resistances of the FPC boards 1s in the inventive examples 1 to 12 and the comparative examples 1 and 2. As illustrated in Fig. 10, a pair of FPC boards 1s in each of the inventive examples 1 to 12 and the comparative examples 1 and 2 was prepared. The pair of FPC boards 1s was arranged so that surfaces of cover layers 6 opposed each other while carbon paper CP was arranged between the cover layers 6 in the pair of FPC boards 1s. A resistance measuring device (ACmQ HITESTER manufactured by HIOKI E.E. CORPORATION) was connected to the cover layer 6 in each of the FPC board 1s via a connection terminal C and a connection line L. The pair of FPC board 1s was pressed against one surface and the other surface of the carbon paper CP at a pressure of 1 MPa. In the state, the resistance measuring device measured a resistance value between the connection terminals C in the pair of FPC board 1s as a contact resistance.

Table 1 illustrates results of the thickness of the barrier layer 32, the presence or absence of corrosion of the conductor layer 31, and the contact resistance of the FPC board 1s.

**[Table 1]**

| | BARRIER LAYER | | PRESENCE OR ABSENCE OF CORROSION | CONTACT RESISTANCE | |
|---|---|---|---|---|---|
| | PRESENCE OR ABSENCE | THICKNESS | | BEFORE IMMERSION | AFTER IMMERSION |
| INVENTIVE EXAMPLE 1 | YES | 120nm | NO | 23mΩ | 24mΩ |
| INVENTIVE EXAMPLE 2 | YES | 120nm | NO | 19mΩ | 23mΩ |
| INVENTIVE EXAMPLE 3 | YES | 120nm | NO | 23mΩ | 24mΩ |
| INVENTIVE EXAMPLE 4 | YES | 120nm | NO | 20mΩ | 22mΩ |
| INVENTIVE EXAMPLE 5 | YES | 100nm | NO | 21mΩ | 28mΩ |
| INVENTIVE EXAMPLE 6 | YES | 30nm | NO | 22mΩ | 24mΩ |
| INVENTIVE EXAMPLE 7 | YES | 300nm | NO | 22mΩ | 23mΩ |
| INVENTIVE EXAMPLE 8 | YES | 150nm | NO | 20mΩ | 22mΩ |
| INVENTIVE EXAMPLE 9 | YES | 40nm | NO | 21mΩ | 25mΩ |
| INVENTIVE EXAMPLE 10 | YES | 350nm | NO | 22mΩ | 23mΩ |
| INVENTIVE EXAMPLE 11 | YES | 4nm | NO | 24mΩ | 550mΩ |
| INVENTIVE EXAMPLE 12 | YES | 510nm | NO | 24mΩ | 600mΩ |
| COMPARATIVE EXAMPLE 1 | NO | 0nm | YES | 20mΩ | 1634mΩ |
| COMPARATIVE EXAMPLE 2 | NO | 0nm | YES | 21mΩ | 1715mΩ |

As illustrated in Table 1, in the FPC board 1s s in the inventive example 1, as a result of measuring the thickness of the barrier layer 32, the barrier layer 32 having a thickness of 120 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 23 mΩ and 24 mΩ.

In the FPC board 1s in the inventive example 2, as a result of measuring the thickness of the barrier layer 32, the barrier layer 32 having a thickness of 120 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 19 mΩ and 23 mΩ.

In the FPC board 1s in the inventive example 3, as a result of measuring the thickness of the barrier layer 32, the barrier layer 32 having a thickness of 120 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 23 mΩ and 24 mΩ.

In the FPC board 1s in the inventive example 4, as a result of measuring the thickness of the barrier layer 32, the barrier layer 32 having a thickness of 120 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 20 mΩ and 22 mΩ.

In the FPC board 1s in the inventive example 5, as a result of measuring the thickness of the barrier layer 32, the barrier layer 32 having a thickness of 100 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 21 mΩ and 28 mΩ.

In the FPC board 1s in the inventive example 6, as a result of measuring the thickness of the barrier layer 32, the barrier layer 32 having a thickness of 30 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 22 mΩ and 24 mΩ.

In the FPC board 1s in the inventive example 7, as a result of measuring the thickness of the barrier layer 32, the barrier layer 32 having a thickness of 300 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 22 mΩ and 23 mΩ.

In the FPC board 1s in the inventive example 8, as a result of measuring the thickness of the barrier layer 32, the barrier layer 32 having a thickness of 150 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 20 mΩ and 22 mΩ.

In the FPC board 1s in the inventive example 9, as a result of measuring the thickness of the barrier layer 32, the barrier layer 32 having a thickness of 40 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 21 mΩ and 25 mΩ.

In the FPC board 1s in the inventive example 10, as a result of measuring the thickness of the barrier layer 32, the barrier layer 32 having a thickness of 350 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 22 mΩ and 23 mΩ.

In the FPC board 1s in the inventive example 11, as a result of measuring the thickness of the barrier layer 32, the barrier layer 32 having a thickness of 4 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 24 mΩ and 550 mΩ.

In the FPC board 1s in the inventive example 12, as a result of measuring the thickness of the barrier layer 32, the barrier layer 32 having a thickness of 510 nm was formed to cover the main surface E1 and the side surface E3 of the conductor layer 31. As a result of immersing the FPC board 1s in the formic acid solution, the corrosion of the conductor layer 31 was not observed. The contact resistances of the FPC board 1s before and after the immersion in the formic acid solution were respectively 24 mΩ and 600 mΩ.

In the FPC board 1s in the comparative example 1, as a result of measuring the thickness of the barrier layer 32, the barrier layer 32 was not formed in the conductor layer 31. As a result of immersing the FPC board 1s in the formic acid solution, the corrosion of the conductor layer 31 was observed. The contact resistances of the FPC board 1s before and after the immersion in the formic acid solution were respectively 20 mΩ and 1634 mΩ.

In the FPC board 1s in the comparative example 2, as a result of measuring the thickness of the barrier layer 32, the barrier layer 32 was not formed in the conductor layer 31. As a result of immersing the FPC board 1s in the formic acid solution, the corrosion of the conductor layer 31 was observed. The contact resistances of the FPC board 1s before and after the immersion in the formic acid solution were respectively 21 mΩ and 1715 mΩ.

From the results in the inventive examples 1 to 7 and the comparative examples 1 and 2, it was confirmed that the barrier layer 32 was formed to cover the main surface E1 and the side surface E3 of the conductor layer 31 by applying the cover layer precursor 60 containing a heterocyclic compound on the main surface E1 and the side surface E3 of the conductor layer 31 and performing curing processing of the coating layer precursor 60 under a predetermined condition. From the result in the inventive example 8, it was confirmed that the barrier layer 32 was formed to cover the main surface E1 and the side surface E3 of the conductor layer 31 by applying a solution containing a heterocyclic compound was applied on the main surface E1 and the side surface E3 of the conductor layer 31 and performing curing processing of the solution under a predetermined condition.

From the results in the inventive examples 1 to 12 and the comparative examples 1 and 2, when the barrier layer 32 was formed in the conductor layer 31, it was confirmed that the conductor layer 31 did not corrode even if the conductor layer 31 contacted the formic acid solution. Particularly, in the inventive examples 1 to 10, it was confirmed that the contact resistance of the FPC board 1s was hardly increased.

While preferred embodiments of the present invention have been described above, it is to be understood that variations and modifications will be apparent to those skilled in the art.

## Claims

1. A printed circuit board comprising:
an insulating layer;
a conductor layer having a predetermined pattern and having first and second main surfaces and a side surface while being formed on said insulating layer so that said second main surface opposes said insulating layer;
a barrier layer formed on at least a partial region of said first main surface and said side surface of said conductor layer and having higher corrosion resistance to acids than that of said conductor layer; and
a conductive cover layer that covers said first main surface and said side surface of said conductor layer and said barrier layer.

2. The printed circuit board according to claim 1, wherein said barrier layer includes a heterocyclic compound.

3. The printed circuit board according to claim 2, wherein said heterocyclic compound includes nitrogen.

4. The printed circuit board according to claim 2, wherein said heterocyclic compound includes an azole-based compound.

5. The printed circuit board according to claim 2, wherein said heterocyclic compound includes at least one of a tetrazole derivative, a diazole derivative, a thiadiazole derivative, and a triazole derivative.

6. The printed circuit board according to claim 2, wherein said heterocyclic compound includes a tetrazole derivative expressed by the following formula (1), where R1 and R2 are the same as or different from each other, and are each a hydrogen atom or a substituent group:

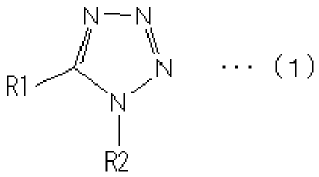

7. The printed circuit board according to claim 2, wherein said heterocyclic compound includes a benzotriazole derivative expressed by the following formula (2), where R3 and R4 are the same as or different from each other, and are each a hydrogen atom or a substituent group:

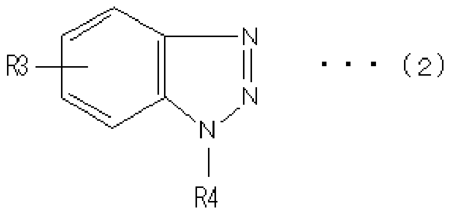

8. The printed circuit board according to any one of the previous claims, wherein the thickness of said barrier layer is not less than 1 nm and not more than 1000 nm.

9. The printed circuit board according to any one of the previous claims, wherein said cover layer includes a resin composition.

10. The printed circuit board according to claim 9, wherein said resin composition includes at least one of phenol resin, epoxy resin, polyester resin, polyurethane resin, and polyimide resin.

11. The printed circuit board according to any one of the previous claims, wherein said cover layer includes a conductive material, the conductive material preferably including at least one of a carbon material and a metal material.

12. A fuel cell comprising:
a cell element;
the printed circuit board according to any one of the previous claims, arranged as an electrode of said cell element; and
a casing that accommodates said cell element and said printed circuit board.

13. A method for manufacturing a printed circuit board, comprising the steps of:
forming a conductor layer having a predetermined pattern and having first and second main surfaces and a side surface on said insulating layer so that said second main surface opposes said insulating layer; and
forming a barrier layer having higher corrosion resistance to acids than that of said conductor layer on at least a partial region of said first main surface and said side surface of said conductor layer while forming a conductive cover layer that covers said first main surface and said side surface of said conductor layer and said barrier layer.

14. The method according to claim 13, wherein
the step of forming said barrier layer and said cover layer comprises the steps of
mixing a resin composition, a conductive material, and a heterocyclic compound, to prepare a cover layer precursor,
applying said cover layer precursor to at least the partial region of said first main surface and said side surface of said conductor layer, and
heating said cover layer precursor.

15. The method according to claim 13, wherein
the step of forming said barrier layer and said cover layer comprises the steps of
forming a barrier layer having higher corrosion resistance to acids than that of said conductor layer on at least the partial region of said first main surface and said side surface of said conductor layer, and
forming a conductive cover layer that covers said main surface and said side surface of said conductor layer and said barrier layer.
